# EUROPÄISCHE PATENTSCHRIFT

(11) **EP 1 279 208 B1**
(45) Veröffentlichungstag und Bekanntmachung des Hinweises auf die Patenterteilung: **08.11.2006**
(21) Anmeldenummer: 01929587.2
(22) Anmeldetag: 20.04.2001
(51) Int. Cl.: H01S 5/068, H01S 5/0683

(54) **MONOLITHISCH INTEGRIERTER SCHALTKREIS ZUM REGELN DER LICHTLEISTUNG EINER LASERDIODE**
MONOLITHICALLY INTEGRATED SWITCHING CIRCUIT FOR REGULATING THE LUMINOUS POWER OF A LASER DIODE
CIRCUIT MONOLITHIQUE INTEGRE POUR REGULER LE FLUX LUMINEUX D'UNE DIODE LASER

(30) Priorität: 02.05.2000 DE 20007884 U
(43) Veröffentlichungstag der Anmeldung: 29.01.2003
(73) Patentinhaber: IC-HAUS GmbH, D-55294 Bodenheim (DE)
(72) Erfinder: HERZ, Manfred, 55130 Mainz (DE)
(74) Vertreter: Kampfenkel, Klaus
(86) Internationale Anmeldenummer: PCT/EP2001/004488
(87) Internationale Veröffentlichungsnummer: WO 2001/084681

(56) Entgegenhaltungen:
- EP-A- 0 596 357
- EP-A- 0 910 143
- DE-A- 4 010 054
- US-A- 4 872 080
- US-A- 5 309 461
- US-A- 5 844 928
- CAFFERTY M S ET AL: "STABLE CURRENT SUPPLY WITH PROTECTION CIRCUITS FOR A LEAD-SALT LASER DIODE" REVIEW OF SCIENTIFIC INSTRUMENTS, AMERICAN INSTITUTE OF PHYSICS. NEW YORK, US, Bd. 60, Nr. 9, 1. September 1989 (1989-09-01), Seiten 2896-2901, XP000069694 ISSN: 0034-6748
- PATENT ABSTRACTS OF JAPAN vol. 008, no. 277 (E-285), 18. Dezember 1984 (1984-12-18) & JP 59 147476 A (HITACHI KOKI KK), 23. August 1984 (1984-08-23)
- SAAM B.T.; CONRADI M.S.: 'Protection circuitry for high-power diode laser arrays' REVIEW OF SCIENTIFIC INSTRUMENTS Bd. 69, Nr. 6, Juni 1998, AIP, Seiten 2230 - 2232, XP012036603
- 'Improved driver circuit for semiconductor laser' RESEARCH DISCLOSURE Bd. 249, Nr. 4, Januar 1985,

## Beschreibung

Die Erfindung betrifft einen monolithisch integrierten Schaltkreis zum Regeln der Lichtleistung einer mit wenigstens einer Fotodiode optisch gekoppelten Laserdiode.

Laserdioden sind empfindliche Halbleiter-Bauelemente, die insbesondere beim Auftreten von Strom-/Spannungstransienten zerstört werden können. Handelsübliche Treiber für Laserdioden werden beispielsweise als integrierte Schaltungen hergestellt, die den Monitorstrom einer mit der Laserdiode optisch gekoppelten Fotodiode regeln, um auf diese Weise indirekt die Lichtleistung der an den Treiber angeschalteten Laserdiode zu kontrollieren.

Die handelsüblichen Laserdioden-Treiber sind jedoch nicht in der Lage, angeschaltete Laserdioden gegen Strom-/Spannungstransienten, vor zu hohen Temperaturen in der integrierten Schaltung und vor zu hohen Strömen, die beispielsweise durch Beschädigung der Laserdiode oder durch eine Unterbrechung der Rückkoppelung des Regelkreises der integrierten Schaltung ausreichend zu schützen.

Aus der EP 0 596 357 A1 ist ein Regelkreis zum Regeln der Lichtleistung einer Laserdiode bekannt, der unter anderem Mittel zum Schutz der Laserdiode aufweist. Die Schutzmittel enthalten unter anderem einen sogenannten Crowbar-Schalter, der parallel zu einer Laserdiode geschaltet ist. Dieser Schalter dient dazu, den von einer spannungsgesteuerten Stromquelle gelieferten Steuerstrom im Störfall an der Laserdiode vorbei zu führen. Der Crowbar-Schalter dient nicht dazu, im Störfall die Regelung des Steuerstroms und damit die Regelung der Lichtleistung der Laserdiode zu unterbrechen.

Aus der EP 0 910 143 A2 ist eine Laserdioden-Schutzschaltung bekannt. Die Schutzschaltung weist unter anderem eine Strombegrenzungsschaltung auf, die Bestandteil eines Regelkreises zur Regelung des Steuerstroms der Laserdiode ist. Die Strombegrenzungsschaltung dient dazu, den Laserstrom derart zu regeln, dass an den Eingängen eines Komparators die Bedingung vp=vr gilt. Die Strombegrenzungsschaltung dient jedoch nicht dazu, die Regelung des Steuerstroms und somit die Regelung der Lichtleistung der Laserdiode nach Auftritt eines Störfalls zu unterbrechen.

Der Erfindung liegt daher die Aufgabe zugrunde, einen monolithisch integrierten Schaltkreis zum Regeln der Lichtleistung einer Laserdiode zu schaffen, der eine angeschaltete Laserdiode vor Zerstörungen umfassend schützen kann.

Diese Aufgabe löst die Erfindung mit den Merkmalen des Anspruchs 1.

Danach ist ein monolithisch integrierter Schaltkreis zum Regeln der Lichtleistung einer mit wenigstens einer Fotodiode optisch gekoppelten Laserdiode vorgesehen. Erste Anschlusskontakte sind zum Anschalten wenigstens einer Laserdiode und zum Anschalten einer mit der Laserdiode optisch gekoppelten Fotodiode vorgesehen. Darüber hinaus ist in dem monolithisch integrierten Schaltkreis eine integrierte Einrichtung zum Regeln des Steuerstroms wenigstens einer angeschalteten Laserdiode mit Hilfe der Fotodiode implementiert. Eine Versorgungsspannung kann an zweite Anschlusskontakte des monolithisch integrierten Schaltkreises angelegt werden. Zudem ist eine mit einem Eingang der integrierten Einrichtung verbundene integrierte Schalteinrichtung vorgesehen, der eine Speichereinrichtung zugeordnet ist. Um zu verhindern, dass ein zu hoher Steuerstrom fließt, werden Signale, die Einfluß auf die Höhe des Steuerstromes haben, überwacht. Die Speichereinrichtung ist unter Ansprechen auf das Abweichen wenigstens eines überwachten Signals von einem vorbestimmten Sollwert in einen vorbestimmten Zustand setzbar und kann die Schalteinrichtung aktivieren, den zum Regeln der Lichtleistung der Laserdiode zugeführten Steuerstrom auf einem vorbestimmten, reduzierten Wert, der vorzugsweise 0 Ampere beträgt zu halten, solange die Speichereinrichtung in dem vorbestimmten Zustand gesetzt ist. Die Speichereinrichtung ist ferner unter Ansprechen auf ein erneutes Anlegen einer Versorgungsspannung an die zweiten Anschlusskontakte rücksetzbar, um die Schalteinrichtung zu deaktivieren.

Ferner ist ein erster, mit der Speichereinrichtung verbundener integrierter Detektor zum Erfassen der Höhe des einer angeschalteten Laserdiode zum Regeln der Lichtleistung zugeführten Steuerstroms und zum Überwachen eines ersten Signals, welches anzeigt, dass der Steuerstrom eine vorbestimmte Höhe überschritten hat, vorgeshen.

Ein zweiter, mit der Speichereinrichtung verbundener integrierter Detektor dient dem Erfassen der Temperatur innerhalb des Schaltkreises dem Überwachen eines zweiten Signals, welches das Überschreiten einer vorbestimmten Temperatur innerhalb des Schaltkreises anzeigt.

Die integrierte Einrichtung zum Regeln des Steuerstroms einer angeschalteten Laserdiode enthält ein Differenzierglied, dessen erster Eingang zum Verbinden mit einer Fotodiode vorgesehen ist, dessen zweiter Eingang mit einer internen Referenzspannungsquelle verbunden sein kann und dessen Ausgang mit.dem Eingang eines integrierten Leistungstreibers verbunden ist, der den geregelten Steuerstrom zum Regeln der Lichtleistung einer angeschalteten Laserdiode liefert. Auch die Schalteinirchtung ist mit dem Eingang des Leistungstreibers verbunden

Mit den zweiten Anschlusskontakten ist eine integrierte Einrichtung zum Unterdrücken von Strom- und/oder Spannungstransienten vorgesehen, die zweckmäßigerweise auch mit wenigstens einem der ersten Anschlusskontakte verbunden ist. Auf diese Weise ist der Pfad zwischen den ersten und zweiten Anschlusskontakten, d.h. der Pfad zwischen einer angeschalteten Versorgungsspannung und einer angeschalteten Laserdiode gegen Strom- und/oder Spannungstransienten geschützt.

Bedeutend hierbei ist, dass die Einrichtung zum Unterdrücken von Strom- und/oder Spannungstransienten integraler Bestandteil des monolithisch integrierten Schaltkreises ist.

Um zu verhindern, dass die Laserdiode beim Ausschalten in Folge der in den Leitungen enthaltenen Induktivitäten durch Spannungsspitzen beschädigt wird, ist parallel zu einer angeschalteten Laserdiode in dem monolithisch integrierten Schaltkreis eine Freilaufeinrichtun integriert, die beispielsweise als antiparallel zur Laserdiode geschaltete Freilaufdiode oder als Transistor ausgebildet sein kann.

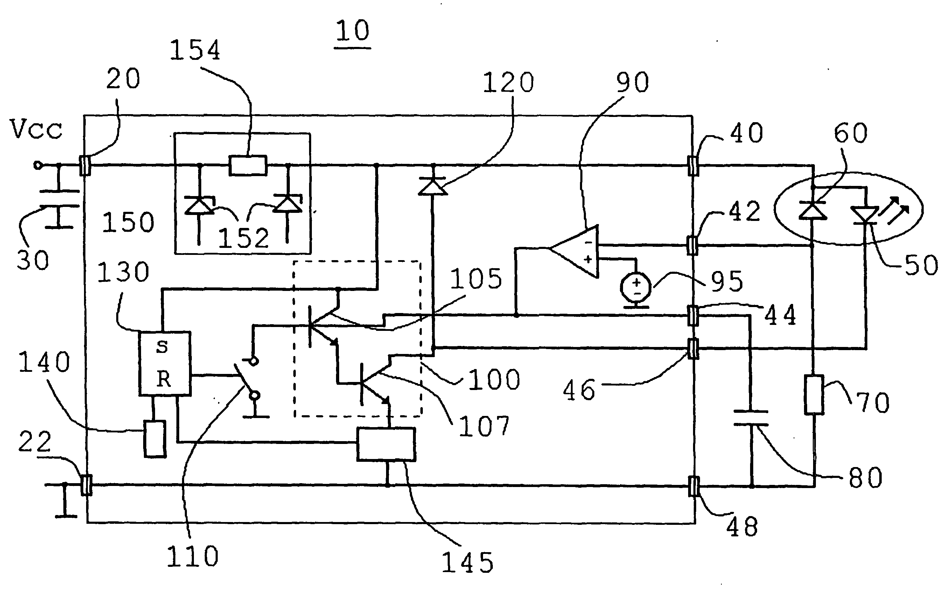

Die Erfindung wird nachstehend anhand eines Ausführungsbeispieles in Verbindung mit der beigefügten Figur näher erläutert.

Die Figur zeigt einen allgemein mit 10 bezeichneten monolithisch integrierten Schaltkreis, der als Treiber für eine Laserdiode ausgebildet ist. Der nachfolgend als Laserdioden-Treiber bezeichnete monolithisch integrierte Schaltkreis 10 weist Anschlusskontakte 20 und 22 auf, an die eine Versorgungsspannungsquelle angeschaltet werden kann (nicht dargestellt), die beispielsweise eine Gleichspannung von 2,4 bis 6 Volt liefern kann. Der mit dem Anschlusskontakt 20 verbundene Kondensator 30 dient der Glättung der Versorgungsspannung. Der Laserdioden-Treiber 10 weist fünf weitere Anschlusskontakte 40, 42, 44, 46, 48 auf, an die eine Laserdiode 50 und eine mit der Laserdiode optisch gekoppelte Fotodiode 60 angeschaltet werden können. Hierbei ist beispielsweise die Kathode der Fotodiode 60 und die Anode der Laserdiode 50 an den Anschlusskontakt 40 angeschlossen. Die Anode der Fotodiode 60 ist mit dem Anschlusskontakt 42 des integrierten Laserdioden-Treibers 10 verbunden. Die Anode der Fotodiode 60 ist ferner über einen Widerstand 70 mit dem Anschlusskontakt 48 verbunden. Wie nachfolgend noch näher erläutert wird, dient der Widerstand 70, dessen Wert zwischen 0,2 und 50 Kiloohm liegen kann, der Definition des Sollstroms der Fotodiode 60. Die Kathode der Laserdiode 50 ist in diesem Ausführungsbeispiel mit dem Anschlusskontakt 46 des Laserdioden-Treibers verbunden. Zur Stabilisierung des in dem Laserdioden-Treibers 10 implementierten Regelkreises und zur Bestimmung der Zeitkonstante des Regelkreises ist zwischen die Anschlusskontakte 44 und 48 ein Kondensator 80 geschaltet. Wie die Figur ferner zeigt, liegt der Anschlusskontakt 22 auf Masse.

Zur Regelung des Steuerstroms für die Laserdiode 50 ist ein Differenzierglied 90 in dem Laserdioden-Treiber 10 integriert, dessen invertierender Eingang mit dem Anschlusskontakt 42 und somit mit der Anode der Fotodiode 60 verbunden ist. Der nicht-intertierende Eingang des Differenziergliedes 90 ist mit einer Referenzspannungsquelle 95 verbunden, die beispielsweise eine Gleichspannung von 0,5 Volt liefert. Der Ausgang des Differenziergliedes 90 ist mit dem Eingang eines Leistungstreibers 100 verbunden, der im vorliegenden Beispiel aus einem npn-Vortransistor 105 und einem npn-Haupttransistor 107 besteht. Hierbei ist der Ausgang des Differenziergliedes 90 mit der Basis des Vortransistors 105 verbunden. Der Kollektor des Vortransistors 105 ist ferner mit dem Anschlusskontakt 40 verbunden. An die Basis des Vortransistors 105 ist eine lediglich schematisch dargestellte Schalteinrichtung 110 angeschaltet, deren Funktion weiter unten noch näher erläutert wird. Der Emitter des Vortransistors 105 ist mit der Basis des Haupttransistors 107 verbunden. Der Kollektor des Haupttransistors 107 ist mit dem Anschlusskontakt 46 und somit mit der Kathode der Laserdiode 50 zur Lieferung des Steuerstroms verbunden. Der Kollektor des Haupttransistors 107 ist ferner über eine Freilaufeinrichtung 120 mit dem Anschlusskontakt 40 verbunden. Im vorliegenden Beispiel ist die Freilaufeinrichtung durch eine antiparallel zur Laserdiode 50 geschalteten Diode 120 implementiert. Die Freilaufdiode dient als Transientenschutz für die Laserdiode 50, um im Ausschaltzeitpunkt die in den Leitungsinduktivitäten gespeicherte Energie über die Freilaufdiode abführen zu können, und somit Spannungsspitzen von der Laserdiode 50 fernzuhalten. Der Emitter des Haupttransistors 107 ist mit dem Eingang eines Stromdetektors 145 verbunden, der den Steuerstrom zur Laserdiode 50 überwacht. Der Stromdetektor 145 ist einmal mit dem Anschlusskontakt 22 und zum anderen mit dem R-Eingang einer Speichereinrichtung 130 verbunden, die in diesem Beispiel als RS-Flip-Flop ausgebildet ist. Ferner ist ein Temperaturdetektor 140 in dem Laserdioden-Treiber 10 integriert, dessen Ausgang mit einem weiteren R-Eingang des RS-Flip-Flops 130 verbunden ist. Der S-Eingang des RS-Flip-Flops 130 ist mit dem Kollektor des Vortransistors 105 verbunden. Zwischen den Anschlusskontakt 20 und den Anschlusskontakt 40 ist eine Einrichtung 150 zum Unterdrücken von Strom- und/oder Spannungstransienten geschaltet, die über die Spannungsversorgungseinrichtung oder andere Störquellen in den Laserdioden-Treiber 10 eingekoppelt werden. Die Unterdrückungseinrichtung 150 umfasst beispielsweise zwei parallel zueinander geschaltete Zenerdioden 152, deren Kathoden durch einen Widerstand 154 getrennt sind. Die Anodenanschlüsse der Zenerdioden 152 sind beispielsweise mit einem freien Sternpunkt verbunden. Durch diese Verschaltung fungiert sowohl die Unterdrückungseinrichtung 150 als auch die Freilaufdiode 120 als Verpolschutz für den Laserdioden-Treiber 10. Dies bedeutet, dass, wenn eine Versorgungsspannungsquelle versehentlich mit dem Pluspol an den Anschlusskontakt 22 angeschlossen wird, kein nennenswerter Strom zur Laserdiode 50 fließt.

Nachfolgend wird die Funktionsweise des Laserdioden-Treibers 10 näher erläutert.

Im normalen, ungestörten Betriebszustand ist die Schalteinrichtung 110, die mit der Speichereinrichtung 130 verbunden ist, geöffnet. Demzufolge wird über den Ausgang des Differenziergliedes 90 ein Potential an die Basis des Vortransistors 105 angelegt, das den Vortransistor 105 und den Haupttransistor 107 ansteuert, so dass der Haupttransistor 107 leitet. In diesem Zustand fließt, verursacht durch die angelegte Versorgungsspannung, ein Strom über den Anschlusskontakt 20, den Anschlusskontakt 40, die Laserdiode 50, den Anschlusskontakt 46, die Kollektoremitterstrecke des Haupttransistors 107 und den Stromdetektor 120 zum Anschlusskontakt 22, der auf Masse gelegt ist. Die Regelung der Lichtleistung der Laserdiode 50 erfolgt mit Hilfe der Fotodiode 60, die das von der Laserdiode 50 emittierte Licht in einen Fotostrom umwandelt, dessen maximaler Wert durch den Widerstand 70 und die Referenzspannung 95 festgelegt ist. Im Wesentlichen wird der Regelkreis durch das Differenzierglied 90, die Referenzspannungsquelle 95,den Leistungstreiber 100, die Fotodiode 60 und die Laserdiode 50 gebildet. Der von der Fotodiode 60 erzeugte Strom führt über den Widerstand 70 zu einem Spannungsabfall, der an den invertierenden Eingang des Differenziergliedes 90 angelegt wird. Dieses Potential wird mit der von der Referenzspannungsquelle 95 bereitgestellten Gleichspannung, im vorlegenden Fall 0,5V, die an dem nichtinvertierenden Eingang des Differenziergliedes anliegt, verglichen. Auf diese Weise erfolgt eine Regelung des am Anschlusskontakt 42 anliegenden Spannungspotentials auf 0,5 Volt. Überschreitet das Spannungspotential am Anschlusskontakt 42 0,5 Volt, reduziert das Differentierglied 90 über dessen Ausgang das Potential an der Basis des Vortransistors 105, wodurch der Haupttransistor 107 hochohmiger und der Steuerstrom zur Laserdiode 50, der die Lichtleistung steuert, reduziert wird. Solange das Potential am Anschlusskontakt 42 kleiner als 0,5 Volt ist, erhöht das Differenzierglied 90 das Spannungspotential an der Basis des Vortransistors 105, wodurch die Kollektor-Emitter-Strecke des Haupttransistors 107 niederohmiger wird, und ein höherer Steuerstrom durch die Laserdiode fließt; dadurch wird auch die Lichtleistung erhöht. Auftretende Spannungs- und/oder Stromtransienten, die über den Anschlusskontakt 20 eingekoppelt werden, werden durch die Einrichtung 150 zum Unterdrücken von Strom- und/oder Spannungstransienten von der Laserdiode 50 ferngehalten.

Bisher wurde der normale, störungsfreie Betrieb des Laserdioden-Treibers 10 erläutert. Nunmehr werden zwei Störungsfälle beschrieben, auf die der Treiber 10 reagieren kann.

Gemäß einem ersten Szenario ermittele der Temperaturdetektor 140 das Überschreiten einer vorbestimmten Betriebstemperatur des Laserdioden-Treibers 10. Daraufhin wird das RS-Flip-Flop 130 über das Ausgangssignal des Temperaturdetektors 140 gesetzt. Unter Ansprechen darauf wird die Schalteinrichtung 110 aktiviert, d.h. der symbolisch dargestellte Schalter geschlossen. Da der Schalter im vorliegenden Beispiel unmittelbar auf Masse gelegt ist, wird das Potential an der Basis des Vortransistors 105 auf 0 Volt gezogen, wodurch der Haupttransistor 107 hochohmig wird, so dass kein Steuerstrom mehr durch die Laserdiode 50 fließt. Mit anderen Worten wird der Steuerstrom durch die Laserdiode 50 auf 0 Ampere begrenzt. Ist die Schalteinrichtung 110 jedoch zum Beispiel über eine Diode (nicht dargestellt) mit der Basis des Vortransistors 105 verbunden, kann der Steuerstrom auf einen vorbestimmten Wert, der größer als 0 Ampere ist, begrenzt werden. Die Schalteinrichtung 110 bleibt solange aktiviert, d.h. der Schalter ist solange geschlossen, wie das RS-Flip-Flop 130 gesetzt bleibt. Sobald die zuvor von dem Laserdioden-Treiber 10 abgetrennte Versorgungsspannung erneut an die Anschlusskontakte 20 und 22 angelegt wird, wird dieser Zustand über den S-Eingang dem RS-Flip-Flop 130 mitgeteilt. Das RS-Flip-Flop 130 wird dadurch zurückgesetzt und die Schalteinrichtung 110 deaktiviert, d. h. der Schalter wird wieder geöffnet. In diesem Moment befindet sich der Laserdioden-Treiber 10 wieder im normalen Betrieb und die Lichtleistung der Laserdiode 50 kann über den Regelkreis geregelt werden.

Die durch den Temperaturdetektor 140 ausgelöste Abschaltprozedur des Laserdioden-Treibers 10 läuft auch dann ab, wenn der Stromdetektor 145 einen Steuerstrom durch die Laserdiode 50 mißt, der einen vorbestimmten Stromwert überschreitet. Auch hier wird das Überschreiten des Stromwertes an den R-Eingang des RS-Flip-Flops 130 signalisiert, woraufhin die Schalteinrichtung 110 aktiviert, d.h. der Schalter geöffnet wird. Ein Rücksetzen des RS-Flip-Flops 130 erfolgt wiederum durch erneutes Anlegen der zuvor abgeschalteten Versorgungsspannungsquelle.

### Bezugszeichen

- 10: monolithisch integrierter Laserdioden-Treiber
- 20, 22: Anschlusskontakte
- 30: Kondensator
- 40-48: Anschlusskontakte
- 50: Laserdiode
- 60: Fotodiode
- 70: Widerstand
- 80: Kondensator
- 90: Differenzierglied
- 95: Referenzspannungsquelle
- 100: Leistungstreiber
- 105: Vortransistor
- 107: Haupttransistor
- 110: Schalteinrichtung
- 120: Freilaufdiode
- 130: Speichereinrichtung, RS-Flip-Flop
- 140: Temperaturdetektor
- 145: Stromdetektor
- 150: Transienten-Schutzeinrichtung
- 152: Zenerdioden
- 154: Widerstand

## Patentansprüche

1. Monolithisch integrierter Schaltkreis (10) zum Regeln der Lichtleistung einer mit wenigstens einer Fotodiode (60) optisch gekoppelten Laserdiode (50), mit
ersten Anschlusskontakten (40, 42, 44, 46, 48) zum Anschalten wenigstens einer Laserdiode und zum Anschalten wenigstens einer mit dieser optisch gekoppelten Fotodiode (60),
einer integrierten Einrichtung (90, 100) zum Regeln des Steuerstromes wenigstens einer angeschalteten Laserdiode (50) mit Hilfe der Fotodiode (60),
zweiten Anschlusskontakte (20, 22) zum Anlegen einer Versorgungsspannung,
einer mit einem Eingang der integrierten Einrichtung (90, 100) verbundenen integrierten Schalteinrichtung (110), und mit
einer der integrierten Schalteinrichtung (110) zugeordneten Speichereinrichtung (130), die
a) unter Ansprechen auf das Abweichen wenigstens eines überwachten Signals von einem vorbestimmten Sollwert in einen vorbestimmten Zustand setzbar ist sowie die Schalteinrichtung (110) aktivieren kann, um den zum Regeln der Lichtleistung der Laserdiode (50) zugeführten Steuerstrom auf einem vorbestimmten, reduzierten Wert zu halten, solange die Speichereinrichtung (130) in dem vorbestimmten Zustand gesetzt ist, und die
b) unter Ansprechen auf ein erneutes Anlegen einer Versorgungsspannung an die zweiten Anschlusskontakte (20, 22) rücksetzbar ist, um die Schalteinrichtung (110) zu deaktivieren.

2. Monolithisch integrierter Schaltkreis nach Anspruch 1,
**gekennzeichnet durch**
einen ersten, mit der Speichereinrichtung (130) verbundenen integrierten Detektor (145) zum Erfassen der Höhe des einer angeschalteten Laserdiode (50) zum Regeln der Lichtleistung zugeführten Steuerstromes und zum Überwachen eines ersten Signals, welches anzeigt, dass der Steuerstrom eine vorbestimmte Höhe überschritten hat.

3. Monolithisch integrierter Schaltkreis nach Anspruch 1 oder 2,
**gekennzeichnet durch**
einen zweiten, mit der Speichereinrichtung (130) verbundenen integrierten Detektor (140) zum Erfassen der Temperatur innerhalb des Schaltkreises und zum Überwachen eines zweiten Signals, welches das Überschreiten einer vorbestimmten Temperatur innerhalb des Schaltkreises anzeigt.

4. Monolithisch integrierter Schaltkreis nach einem der Ansprüche 1 bis 3,
**dadurch gekennzeichnet, dass**
die Speichereinrichtung (130) ein RS-Flip-Flop ist.

5. Monolithisch integrierter Schaltkreis nach einem der Ansprüche 1 bis 4,
**dadurch gekennzeichnet, dass**
die integrierte Einrichtung (90, 100) zum Regeln des Steuerstroms wenigstens einer angeschalteten Laserdiode (50) einen Differenzverstärker (90) enthält, dessen erster Eingang zum Verbinden mit einer Fotodiode (60) vorgesehen ist, dessen zweiter Eingang mit einer Referenzspannungsquelle (95) verbunden ist und dessen Ausgang mit dem Eingang eines Leistungstreibers (100) verbunden ist, der den geregelten Steuerstrom zum Regeln der Lichtleistung einer angeschalteten Laserdiode (50) liefert, und dass
die Schalteinrichtung (110) mit dem Eingang des Leistungstreibers (100) verbunden ist.

6. Monolithisch integrierter Schaltkreis nach einem der Ansprüche 1 bis 5,
**gekennzeichnet durch**
eine integrierte, mit den zweiten Anschlusskontakten verbundene Einrichtung (150) zum Unterdrücken von Strom- und/oder Spannungstransienten.

7. Monolithisch integrierter Schaltkreis nach einem der Ansprüche 1 bis 6,
**gekennzeichnet durch**
eine integrierte Freilaufeinrichtung (120), die antiparallel zu einer angeschalteten Laserdiode (50) geschaltet ist.

## Claims

1. Monolithically integrated switching circuit (10) for regulating the light output of a laser diode (50) optically coupled to at least one photodiode (60), having first connecting contacts (40, 42, 44, 46, 48) for connecting at least one laser diode and for connecting at least one photodiode (60) optically coupled thereto,
an integrated device (90, 100) for regulating the control current of at least one connected laser diode (50) with the aid of the photodiode (60),
second connecting contacts (20, 22) for providing a power supply, and
an integrated switching device (110) connected to the input of the integrated device (90, 100), and having
a storage device (130) assigned to the integrated switching device (110), which
a) in response to the deviation of at least one monitored signal from a predefined target value can be set to a predefined state and can activate the switching device (110), in order to keep the control current supplied for regulating the light output of the laser diode (50) to a predefined reduced value so long as the storage device (130) is set in the predefined state, and which
b) in response to renewed provision of a power supply to the second connecting contacts (20, 22) can be reset in order to deactivate the switching device (110).

2. Monolithically integrated switching circuit according to claim 1,
**characterised by**
a first integrated detector (145) connected to the storage device (130) for detecting the level of the control current supplied to a connected laser diode (50) for regulating the light output and for monitoring a first signal which indicates that the control current has exceeded a predefined level.

3. Monolithically integrated switching circuit according to claim 1 or 2,
**characterised by**
a second integrated detector (140) connected to the storage device (130) for detecting the temperature within the switching circuit and for monitoring a second signal which indicates the exceeding of a predefined temperature within the switching circuit.

4. Monolithically integrated circuit according to one of the claims 1 to 3,
**characterised in that**
the storage device (130) is an RS-Flip-Flop.

5. Monolithically integrated switching circuit according to one of the claims 1 to 4,
**characterised in that**
the integrated device (90, 100) for regulating the control current of at least one connected laser diode (50) contains a differential amplifier (90), of which the first input is provided for connection to a photodiode (60), of which the second input is connected to a reference power source and of which the output is connected to the input of a power driver (100) which supplies the regulated control current for regulating the light output of a connected laser diode (50), and **in that** the switching device (110) is connected to the input of the power driver (100).

6. Monolithically integrated switching circuit according to one of the claims 1 to 5,
**characterised by**
an integrated device (150) connected to the second connecting contacts for suppressing current and / or voltage transients.

7. Monolithically integrated switching circuit according to one of the claims 1 to 6,
**characterised by** an integrated freewheeling device (120) which is connected in an anti-parallel way to a connected laser diode (50).

## Revendications

1. Circuit de commutation intégré monolithique (10) servant à régler la puissance lumineuse d'une diode laser (50) couplée optiquement à au moins une photodiode (60), comportant :
des premiers contacts de connexion (40, 42, 44, 46, 48) servant à mettre en circuit au moins une diode laser et à mettre en circuit au moins une photodiode (60) couplée optiquement à cette dernière ;
un dispositif intégré (90, 100) servant à régler le courant de commande d'au moins une diode laser mise en circuit (50) à l'aide de la photodiode (60) ;
des seconds contacts de connexion (20, 22) servant à appliquer une tension d'alimentation ;
un dispositif de commutation intégré (110) relié à une entrée du dispositif intégré (90, 100) ; et
un dispositif de mémorisation (130) associé au dispositif de commutation intégré (110), qui :
a) en réaction à l'écart, par rapport à une valeur de consigne prédéterminée, d'au moins un signal surveillé, peut être mis dans un état prédéterminé et peut activer le dispositif de commutation (110), et ce afin de maintenir le courant de commande amené pour régler la puissance lumineuse de la diode laser (50) à une valeur réduite prédéterminée tant que le dispositif de mémorisation (130) est dans l'état prédéterminé ; et qui,
b) en réaction à une nouvelle application d'une tension d'alimentation aux seconds contacts de connexion (20, 22), peut être remis à l'état initial afin de désactiver le dispositif de commutation (110).

2. Circuit intégré monolithique selon la revendication 1, **caractérisé par** un premier détecteur intégré (145) relié au dispositif de mémorisation (130) et servant à détecter le niveau du courant de commande amené pour régler la puissance lumineuse à une diode laser mise en circuit (50), ainsi qu'à surveiller un premier signal qui indique que le courant de commande a dépassé un niveau prédéterminé.

3. Circuit intégré monolithique selon la revendication 1 ou 2, **caractérisé par** un deuxième détecteur intégré (140) relié au dispositif de mémorisation (130) et servant à détecter la température à l'intérieur du circuit de commutation ainsi qu'à surveiller un deuxième signal qui indique le dépassement d'une température prédéterminée à l'intérieur du circuit de commutation.

4. Circuit intégré monolithique selon l'une des revendications 1 à 3, **caractérisé en ce que** le dispositif de mémorisation (130) est une bascule RS.

5. Circuit intégré monolithique selon l'une des revendications 1 à 4, **caractérisé en ce que** le dispositif intégré (90, 100) servant à régler le courant de commande d'au moins une diode laser mise en circuit (50) comprend un amplificateur différentiel (90) dont la première entrée est destinée à être reliée à une photodiode (60), dont la deuxième entrée est reliée à une source de tension de référence (95) et dont la sortie est reliée à l'entrée d'un circuit d'attaque de puissance (100) qui délivre le courant de commande régulé servant à régler la puissance lumineuse d'une diode laser mise en circuit (50), et **en ce que** le dispositif de commutation (110) est relié à l'entrée du circuit d'attaque de puissance (100).

6. Circuit intégré monolithique selon l'une des revendications 1 à 5, **caractérisé par** un dispositif intégré (150) relié aux seconds contacts de connexion et servant à supprimer des pointes de courant et/ou de tension.

7. Circuit intégré monolithique selon l'une des revendications 1 à 6, **caractérisé par** un dispositif de roue libre intégré (120) qui est monté de manière antiparallèle à une diode laser mise en circuit (50).
